# EUROPÄISCHE PATENTSCHRIFT

(11) **EP 2 502 086 B1**
(45) Veröffentlichungstag und Bekanntmachung des Hinweises auf die Patenterteilung: **05.06.2013**
(21) Anmeldenummer: 09752391.4
(22) Anmeldetag: 19.11.2009
(51) Int. Cl.: G01R 31/36, G01R 35/00, G01R 19/00

(54) **VERFAHREN UND VORRICHTUNG ZUR FEHLERKOMPENSIERTEN STROMMESSUNG EINES ELEKTRISCHEN AKKUMULATORS**
METHOD AND DEVICE FOR ERROR-COMPENSATED CURRENT MEASUREMENT OF AN ELECTRICAL ACCUMULATOR
PROCÉDÉ ET DISPOSITIF DE MESURE DE COURANT, À COMPENSATION D'ERREUR, D'UN ACCUMULATEUR ÉLECTRIQUE

(43) Veröffentlichungstag der Anmeldung: 26.09.2012
(73) Patentinhaber: Robert Bosch GmbH, 70442 Stuttgart (DE)
(72) Erfinder: BOEHM, Andre, 70806 Kornwestheim (DE)
(86) Internationale Anmeldenummer: PCT/EP2009/065474
(87) Internationale Veröffentlichungsnummer: WO 2011/060820

(56) Entgegenhaltungen:
- EP-A1- 1 220 413
- EP-A1- 2 019 324
- EP-A1- 2 107 385
- DE-A1-102008 043 799
- US-A- 4 839 597
- US-A- 5 994 876

## Beschreibung

### Stand der Technik

Die Erfindung geht aus von Verfahren zur Fehlerkompensation von Strommessungen und insbesondere von Strommessungen zur Ermittlung eines Ladzustands eines elektrischen Akkumulators, der als Speicher für Traktionsenergie eines Kraftfahrzeugs dient.

Aus der EP 2 019 324 A1 ist ein System zur modellbasierten Vorhersage einer Ausgangsspannung einer Batterie bekannt, wobei ein Steuergerät, ein Spannungs-, ein Strom- und ein Temperatursensor vorgesehen sind, wobei mittels eines Modells für einen Energiefluss der Batterie eine Bestimmung eines Ladezustands (SOC) der Batterie durchgeführt wird.

Aus der EP 1220413 A1 ist ein Vollladungszustandsbeurteilungssystem für Fahrzeugbatterien bekannt, wobei eine Spannungserfassungseinrichtung mit einem Wechselstromgenerator und eine Stromerfassungseinrichtung zum Erfassen eines Stromes, der durch die Batterie fließt, vorgesehen sind, wobei durch eine Bestimmung einer Restkapazität und einem Ladezustand der Batterie ein Korrekturwert des gemessenen Stromes berechnet wird.

Aus der US 5 994 876 A ist ein elektronischer Schaltkreis zum Messen eines gesamten elektrischen Stroms, der zur Speisung einer Last einer Batterie entnommen wird, bekannt, wobei der Schaltkreis einen Widerstand, eine Integrierschaltung, einen Analog-Digital-Wandler und einen Prozessor aufweist, wobei der Prozessor mit der Integrierschaltung und dem Analog-Digital-Wandlers gekoppelt ist.

Zur Strommessung werden Stromsensoren verwendet, beispielsweise so genannte Shunt-Widerstände, durch die der zu messende Strom fließt, oder magnetische Sensoren zur Erfassung des vom Strom erzeugten Magnetfelds. Anhand der abfallenden Spannung kann mittels des Widerstandswert auf den durchflossenen Strom geschlossen werden. Die am Shunt-Widerstand abfallende Spannung wird von (hochohmigen) Messverstärkern oder Pufferstufen aufbereitet und im Falle einer digitalen Weiterverarbeitung an einen Analog/Digital-Wandler übermittelt. Der Analog/Digital-Wandler verwendet zur Umwandlung eine Spannungsreferenz.

Insbesondere durch Temperaturänderungen, aber auch durch andere Einflüsse wie Einstrahlung oder veränderliche Betriebsspannungen, ergeben sich neben den Toleranzfehlern weitere Fehler bei einem derartigen Messaufbau. Insbesondere, wenn der erfasste Strom integriert wird, um daraus auf eine geflossene Ladungsmenge zu schließen, wird auch der Fehleranteil integriert. Bekannte Maßnahmen zur Reduktion derartiger Fehler sind aufwändige Temperaturkompensationsschaltungen, Hochpräzisionswiderstände als Shunt-Widerstand oder Hochpräzisions-Referenzspannungsquellen für den Analog/Digital-Wandler, sowie präzise Messwandler zur Vorverarbeitung des analogen Spannungssignals. Alle diese Maßnahmen führen zu hohen Bauteilkosten und erfordern zudem eine individuelle Kalibrierung jeder einzelnen Messschaltung. Insbesondere hochpräzise Shunt-Widerstände führen bei Hochstromanwendungen, beispielsweise auf dem Gebiet der Kraftfahrzeugtechnik, zu erheblichen Kosten. Ferner ergeben sich bei Shunt-Widerständen mit hohen Widerstandswerten zur Erhöhung der daran abfallenden Spannung, um die Messgenauigkeit zu erhöhen, unerwünscht hohe Verlustleistungen, die unter anderem auch einen selbstinduzierten Temperaturdrift durch die Erwärmung bei der Messung zur Folge haben.

Sämtliche Fehler der Messschaltung sind zueinander unkorreliert und addieren sich somit. Da sich so bei derzeitigen mehrstufigen Messvorrichtungen (Shunt-Widerstand-Pufferstufe-Sample&Hold-Stufe-A/D-Wandler-Microcontroller) ein hoher Fehleranteil ergibt, der sich nur durch kostenintensive, hochpräzise Bauelemente ausgleichen lässt, ist es eine Aufgabe der Erfindung, ein Verfahren und eine Vorrichtung zur fehlerkompensierten Strommessung vorzusehen, mit denen sich eine hohe Präzision auch bei zeitlicher Integration der gemessenen Stromwerte ergibt.

### Offenbarung der Erfindung

Die Erfindung ermöglicht die Verwendung von preiswerten Bauelementen, beispielsweise mit hohen Fertigungstoleranzen, ohne einen hohen Messfehler zu erzeugen. Insbesondere ermöglicht es die Erfindung, hohe Messgenauigkeiten zu erreichen, ohne dass individuelle Kalibrierungen einzelner Schaltungen notwendig sind, um beispielsweise Fertigungstoleranzen zu kompensieren. Insbesondere ermöglicht die erfindungsgemäße Strommessung eine deutliche Erhöhung der Genauigkeit von Ladungszustandsschätzungen, die sich auf den Akkumulator beziehen. Derartige Schätzungen basieren (unter anderem) auf einer Strommessung mittels Shunt, wobei die Stromwerte integriert werden, und sich somit Fehler aufsummieren. Derartige Ladungszustandsschätzungen, auch SOC-Schätzungen (SOC - State of Charge) genannt, sind insbesondere zur Ermittlung der noch verbleibenden Reichweite von Kraftfahrzeugen notwendig, bei denen ein elektrischer Akkumulator (zumindest zum Teil) die Traktionsenergie bereitstellt.

Die Erfindung ist insbesondere zur Strommessung von elektrischen Akkumulatoren geeignet, in denen elektrische Traktionsenergie eines Kraftfahrzeugs gespeichert wird, beispielsweise für Akkumulatoren eines Hybridantriebs oder eines Elektroantriebs eines Personenkraftwagens, eines Nutzfahrzeugs oder anderer Kraftfahrzeuge. Ferner betrifft die Erfindung eine Ladungszustandsschätzung eines Akkumulators mittels integriertem gemessenen Strom bzw. mittels geschätztem Ladungszustand, wobei Erfassungsfehler des gemessene Stroms durch das erfindungsgemäße Verfahren zumindest teilweise kompensiert werden.
Das der Erfindung zugrunde liegende Konzept ist es, neben einer Stromschätzung, die auf der Messung eines Shunt-Widerstands oder eines anderen Stromsensors beruht, einen Schätzer für Ladungen zu verwenden. Die Schätzungen beziehen sich auf eine Ladungsmenge, die innerhalb eines vorbestimmten Zeitintervalls, d.h. innerhalb eines Zeitfensters, dem Akkumulator zugeführt werden oder von diesem abfließen.

Da sich eine derartige Ladung auf ein Zeitfenster bezieht, hat die Ladung auch einen strombezogenen Aspekt, da die Ladung aufgrund des Zeitfensters auf dieses normiert ist und somit im Wesentlichen einen Strom (einen Mittelwert bzw. ein Integral eines Stroms über das Zeitfenster) wiedergibt. Gemäß dem der Erfindung zugrunde liegenden Konzept basiert die Schätzung der relativen Ladung zwar zum einen auf dem gemessenen Strom, jedoch auch auf einer Größe, die sich nicht unmittelbar, sondern indirekt, beispielsweise über ein Modell (oder eine Interpolation) aus dem Strom ergibt. Bezogen auf den Akkumulator basiert der Schätzer somit auf einem Modell, das die physikalischen Eigenschaften des Akkumulators wiedergibt, wobei die Modellsimulation nicht nur auf dem Akkumulatorstrom beruht, sondern auch auf davon nur mittelbar oder nicht abhängende Größen wie Klemmenspannung, Leerlaufspannung oder Akkumulatortemperatur, die Betriebsgrößen darstellen, von denen der Zustand des Akkumulators bzw. der Ladungszustand des Akkumulators abhängt. Somit wird erfindungsgemäß ein Akkumulatormodell des Schätzers betrachtet, das die relative Ladung in Beziehung setzt zu dem Modell, welches durch weitere Betriebsparameter definiert ist, und wobei die Betriebsparameter neben dem Akkumulatorstrom auch andere Betriebsgrößen zur Ermittlung des Zustands der Batterie berücksichtigt werden. Als physikalische Messgrößen, die in die Zustandsbestimmung durch das Modell mittels des Schätzers einfließen, sind somit neben dem gemessenen Akkumulatorstrom auch die Klemmenspannung und die Temperatur des Akkumulators.

Die Erfindung ist insbesondere geeignet, den Ladungszustand (SOC) des Akkumulators zu erfassen, indem der erfindungsgemäß fehlerkompensierte Strom integriert wird und/oder indem der Schätzer nicht nur die Relativladung sondern auch den Ladungszustand unter anderem basierend auf dem fehlerkompensierten Strom schätzt und ausgibt. Erfindungsgemäß hat der SOC-Schätzer zwei Funktionen: zum Einen die Schätzung des Ladungszustands, und zum Anderen die Schätzung der Zeitfenster bezogenen Relativladung um einen (oder mehrere) Kalibrierungspunkte für die Strommessung (durch den Stromsensor) und somit eine geschätzte geflossene Relativladung zu bestimmen. Die Funktion der Erfassung der Kalibrierungszeitpunkte / Fehlererfassungszeitpunkte kann ferner durch Vergleichen des Betrags des gemessenen Stroms, dessen Mittelwert, oder dessen auf das Zeitfenster bezogenen Integrals mit einem Mindestwert (Offsetfehlererfassung) und einem Maximalwert (Skalierungsfehlererfassung) vorgegeben werden. Die Kalibrierungswerte ergeben sich durch Vergleich des gemessenen Stroms mit der geschätzten Relativladung. Die Kalibrierungspunkte werden vom Schätzer nicht nur zeitlich bestimmt, sondern der Schätzer gibt für ein Zeitfenster auch eine Relativladung vor, anhand der die Strommessung kalibriert wird. Wie bereits beschrieben wird erfindungsgemäß kalibriert durch Ermitteln des Offsetfehlers und des Skalierungsfehlers. Der Skalierungsfehler wird aufgrund des ermittelten Offsetfehlers und aufgrund einer weiteren Messung und zugehöriger, vom Schätzer gelieferte Relativladung ermittelt. Die Relativladung bezieht sich auf ein vom Verfahren geeignet zu bestimmendes Zeitfenster.

Das Zeitfenster kann bestimmt werden beispielsweise durch Erfassen eines geeigneten gemessenen Stromwerts oder geschätzten Relativladung, wodurch gemäß einer ersten Ausführungsform das Zeitfenster zur Skalierungsfehlererfassung bei hohen gemessenen Stromwerten oder bei hohen geschätzten Relativladungen gestartet wird. Gemäß einer zweiten Ausführungsform wird das Zeitfenster zur Skalierungsfehlererfassung mit Beendigung des vorhergehenden Zeitfensters gestartet. Treten während des Zeitfensters Bedingungen auf, die zur Skalierungsfehlererfassung ungünstig sind (zeitweise geringe Akkumulatorbelastung, ermittelt aufgrund des gemessenen Stroms oder geschätzten Relativladung), kann das Zeitfenster von der Skalierungsfehlererfassung im nachhinein ausgeschlossen werden, die hierzu ermittelten Werte werden dann verworfen. Zur Erfassung des Offsetfehlers wird das Zeitfenster vorzugsweise ebenso mit Beendigung des vorangehenden Zeitfensters gestartet. Zur Erfassung des Offsetfehlers es nicht unbedingt notwendig, Momentanwerte des Stroms oder momentane Ladungswerte zu Erfassen, wenn gewährleistet ist, dass über das gesamte Zeitfenster der gemessene Strom, das Integral des Stroms oder die auf das Zeitfenster bezogenen Relativladung einen geringen Wert aufweist, d.h. unter einem Maximalwert ist oder im wesentlichen Null beträgt. Das zugehörige Beenden des zur Offsetfehlererfassung verwendeten Zeitfensters richtet sich insbesondere nach dem Integral des gemessenen Stroms bzw. der dem Zeitfenster zugehörigen Relativladung, deren Werte unter einem Maximalwert oder im wesentlichen Null betragen sollten. Das Zeitfenster kann somit fortgeführt werden, bis das Integral des gemessenen Stroms oder die zugehörige geschätzte Relativladung im wesentlichen Null ist, einen Nulldurchgang hat, oder unter dem Maximalwert liegt. Optional kann das Zeitfenster von der Erfassung des Offsetfehlers ausgeschlossen werden (d.h. verworfen werden), wenn trotz geringem Wert des Integrals oder der Relativladung der gemessene Strom zu einem Zeitpunkt innerhalb des Zeitfensters über einem Strom-Schwellwert lag, der einer hohen Belastung (bsp. in der Größenordnung einer Norm-Strombelastung oder einer Maximal-Strombelastung des Akkumulators) entspricht. Dadurch werden Skalierungsfehlereinflüsse bei der Offsetfehlererfassung reduziert.

Das Zeitfenster wird beendet, wenn (i) für Skalierungsfehlererfassung die Dauer der Betrachtung des Stromwert bzw. Relativladung als geeignet zu betrachten ist, beziehungsweise wenn (ii) für die Offsetfehlererfassung der Stromwert bzw. Relativladung geeignete Werte bzw. einen geeigneten Verlauf aufweisen. Geeignet zur Erfassung des Offsetfehlers sind insbesondere Zeitfenster einer geringen Akkumulatorbelastung, in denen Relativladung, gemessener Strom oder dessen auf das begonnene Zeitfenster bezogenes Integral etwa bei Null liegen, einen Nulldurchgang aufweisen bzw. unterhalb einem Maximalwert (vorzugsweise für das gesamte Zeitfenster), und ferner Zeitfenster, in denen das Integral des gemessenen Stroms oder die auf das Zeitfenster bezogene geschätzte Relativladung im wesentlichen Null beträgt oder unter einem Maximalwert ist. Geeignet zur Erfassung des Skalierungsfehlers sind Zeitfenster einer hohen Akkumulatorbelastung, in denen Relativladung oder gemessener Strom ein (relatives) Maximum aufweisen und/oder einen Mindestwert aufweisen, vorzugsweise für das gesamte Zeitfenster. Das Zeitfenster zur Erfassung des Skalierungsfehlers ist vorzugsweise kurz, d.h. kürzer als das Zeitfenster zur Offsetfehlererfassung, beispielsweise ≤2 min, ≤1 min, ≤30 sec, ≤20 sec, ≤10 sec , ≤5 sec öder ≤2 sec. Durch die Kürze des Zeitfensters bei der Skalierungsfehlererfassung wird der sich aufsummierende Fehler resultierend aus einem verbleibenden Offsetfehler reduziert. Anstatt des gemessenen Stroms kann auch dessen zeitliches Integral über das Zeitfenster verwendet werden.

Zur Erfassung des Offsetfehlers werden generell Zeitfenster verwendet, bei denen der integrierte, gemessene Akkumulatorstrom oder die geschätzte Relativladung unter einem Maximalwert liegt oder im wesentlichen Null beträgt. Grundsätzlich kann das Zeitfenster auf nach Erfassung des gemessenen Stroms und der geschätzten Ladung hinsichtlich Beginn und Ende festgelegt werden, so dass zur Offsetfehlererfassung Zeitfenster mit geringem integriertem Akkumulatorstrom (oder einem integrierten Akkumulatorstrom von im wesentlichen null erzeugt werden, und zur Skalierungsfehlererfassung (kurze) Zeitfenster mit einem gemessenen Strom oder geschätzter Relativladung erzeugt werden, deren Wert für das ganze Zeitfenster über einem Mindestwert liegt. Dies kann auch ohne Festlegung des Zeitfensters im Nachhinein erreicht werden, indem das Zeitfensters geeignet beendet wird, wenn die jeweilige Bedingung hinsichtlich integriertem Akkumulatorstrom, geschätzter Relativladung oder auch Zeitdauer des Zeitfensters (bei der Skalierungsfehlerfassung) zutrifft. Nicht geeignete Zeitfenster können verworfen werden, beispielsweise wenn bei der Skalierungsfehlererfassung ein zu niedriger Wert des gemessenen Stroms erfasst wird. Die ermittelten Fehler werden durch Subtraktion (Offsetfehler) bzw. Multiplikation mit einem Kompensationsfaktor (Skalierungsfehler) aus dem Fehler der Strommessung (oder auch des geschätzten Akkumulatorzustands) herausgerechnet.

SOC-Schätzer, die auf einem physikalischen Modell des Akkumulators beruhen, sind aus dem Stand der Technik bekannt, ebenso auch die Kombination derartiger Schätzer mit einer Strommessung und Stromintegration, die auf einem Shunt-Widerstand basiert. Eine derartige Kombination ist beispielsweise in der Anmeldung DE 102008041300.3, Anmeldetag 18. August 2008, beschrieben.

Erfindungsgemäß wird der Schätzer dazu verwendet, eine auf ein Zeitfenster bezogene Ladungsmenge zu schätzen, wobei die Schätzung nicht nur auf dem gemessenen Akkumulatorstrom, sondern auch von der Klemmenspannung, der Temperatur oder einer Kombination hiervon oder von weiteren Betriebsparametern des Akkumulators abhängt. Eine weitere erfindungsrelevante Vorgehensweise ist die Unterteilung des zu kompensierenden Strommessungsfehlers in einen Offsetfehler und einen Skalierungsfehler. Der Offsetfehler wird als Summer aller Offsetfehler aller Messschaltungskomponenten angesehen, wohingegen der Skalierungsfehler als Summe aller Skalierungsfehler aller Messschaltungskomponenten angesehen wird. Dies entspricht der Linearkombination einer Geraden, die den fehlerbehafteten Stromwert mit dem tatsächlich vorliegenden Stromwert in Beziehung setzt. Alternativ kann das Verhältnis gesehen werden als Gerade, die die Gesamtmessfehlerkomponente zu dem tatsächlich fließenden Strom oder zu dem fehlerbehafteten Strommesswert in Beziehung setzt. Im letzteren Fall entspricht der Abstand der Geraden bei einem Strom von Null dem Offsetfehler, wobei die Steigung dem Skalierungsfehler entspricht. Erfindungsgemäß werden Qffsetfehler und Skalierungsfehler getrennt behandelt und gegebenenfalls auch getrennt erfasst und kompensiert, wobei der vom Schätzer abgegebene auf den Zeitrahmen bezogene Ladungswert für den Zeitpunkt der Erfassung der beiden Fehler sowie zur Erfassung der beiden Fehler selbst verwendet wird. Der Offsetfehler wird bei einem Strom von Null erfasst, wobei ein Strom von Null einer vom Schätzer abgegebenen relativen Ladung von Null entspricht. Zur Stromerfassung kann die geschätzte Ladung akkumuliert über das Zeitfenster als Kriterium zur Erfassung des Nulldurchgangs verwendet werden oder alternativ der gemessene Strom als Momentanwert, als zeitlich gemittelter Wert oder insbesondere als über das Zeitfenster integrierter Wert. In gleicher Weise wird der Skalierungsfehler bei hohen Strömen erfasst, vorzugsweise bei einem Maximum, wobei zur Erfassung des Zeitpunkts des relativen Maximums ebenso der vom Schätzer abgegebene relative Ladungswert oder der gemessene Strom verwendet wird. Ferner wird zur Erfassung des Skalierungsfehlers selbst der vom Schätzer abgegebene Ladungswert verwendet, zusammen mit dem entsprechenden gemessenen Strom beziehungsweise dessen zeitliches Integral über das Zeitfenster, um den Fehler als Differenz zu erfassen und um daraus den Korrekturfaktor abzuleiten.

Der Schätzer dient somit erfindungsgemäß zur (wiederkehrenden) Kalibrierung der Strommessung, wobei dadurch zusätzliche Information in das System einfließt, dass der Schätzer den Akkumulatorzustand nicht nur aufgrund des gemessenen Stroms vorsieht, sondern auch weitere Betriebsparameter berücksichtigt, die mit dem Ladungszustand zusammenhängen, und nicht oder nur mittelbar mit dem Akkumulatorstrom zusammenhänge. Insbesondere die Zeitpunkte der Erfassung des Offset- und Skalierungsfehlers werden vom Schätzer ermittelt, sowie auch die dazugehörigen geschätzten Stromwerte, die als Kalibrierungsreferenz für die mittels Stromsensor gemessenen Stromwerte dienen, um den Stromsensor/die Strommessung zu kalibrieren.

Im Folgenden wird ein der erfindungsgemäßen fehlerkompensierten Strommessung zugrunde liegendes Modell erläutert. Der gemessene Strom setzt sich zusammen aus der Summe von Strommessungs-Offsetfehler und tatsächlich fließendem Strom, der mit dem Strommessungs-Skalierungsfehler multipliziert ist. Für das Zeitfenster ergibt sich somit anstatt des zeitlichen Integrals über den tatsächlich fließenden Strom die sich durch Messung ergebende Ladung als Summe aus Integral des Offsetfehlers über das Zeitfenster und Skalierungsfehler multipliziert mit dem Integral des tatsächlich fließenden Stroms über das Zeitfenster. Die auf dem gemessenen, fehlerbehafteten Strom basierende Ladung ergibt sich somit aus der Summe aus Offsetfehler multipliziert mit der Länge des Zeitfensters und dem Skalierungsfehler multipliziert mit der tatsächlich zugeführten oder abgeflossenen Ladung, die die Relativladung bezeichnet, welche während des Zeitfensters in Form des tatsächlich geflossenen Stroms übertragen wurde. Gemäß diesem Modell wird der Offsetfehler als Strom angenommen und der Skalierungsfehler als einheitslose Größe, wobei der Offsetfehler auch als auf das Zeitintervall bezogene Ladungsmenge betrachtet werden kann und der Skalierungsfehler als Differenzstrom oder als Differenzladung. Erfindungsgemäß wird zur Fehlererfassung die geschätzte Relativladung (bezogen auf ein Zeitfenster) einem gemessenen Strom gegenübergestellt. Hierzu wird entweder der gemessene Strom durch Integration über das Zeitfensters auf dieses bezogen, um mit der geschätzten, auf das Zeitfenster bezogenen Relativladung verglichen werden zu können. Prinzipiell ist auch eine Vergleich mögliche, indem die geschätzte Relativladung durch Division auf die Länge des Zeitfensters normiert wird, wobei die so normierte geschätzte Relativladung durch Subtraktion mit dem gemessenen Strom verglichen werden kann. Im letzteren Fall kann der Strom über das Zeitfensters gemittelt werden.

Die oben stehende Betrachtung des tatsächlich gemessenen Stroms kann an diese Betrachtungsweise angepasst werden, wobei anstatt des tatsächlich gemessenen Stroms die tatsächlich für das Zeitfenster erfasste relative Ladungsmenge betrachtet werden kann und eine derartige Integraldarstellung die entsprechende Umwandlung von Strom in Ladung durch Multiplikation mit der Länge des Zeitfensters vorgesehen wird.

Zur Kompensation des oben stehenden Skalierungsfehlers und Offsetfehlers werden vorzugsweise zwei Kompensationsgrößen verwendet, beispielsweise ein Kompensationsstrom, der dem Negativen des Offsetfehlers entspricht, sowie ein Kompensationsfaktor für den Skalierungsfehler, der dem Kehrwert des Skalierungslehlers entspricht. Wird zur Kompensation des Skalierungsfehlers anstatt eines Faktors ein Strom oder eine Ladung verwendet, so können diese auch durch Umkehrung des Vorzeichens der entsprechenden Skalierungsfehlergröße vorgesehen werden. Das der Erfindung zugrunde liegende Konzept sieht jedoch vor, den in welcher Größe auch immer dargestellten Offsetfehler von dem Skalierungsfehler zu trennen, um diese nicht gleichzeitig, vorzugsweise nacheinander zu kompensieren, beispielsweise innerhalb eines iterativen Prozesses, bei dem sich Offsetfehlererfassung und Skalierungsfehlererfassung sowie deren jeweilige Kompensation abwechseln oder im allgemeinen nacheinander ausgeführt werden, beispielsweise alternieren. Insbesondere die (ein- oder mehrmalige) Kompensation des Skalierungsfehlers basiert auf einer (einmaligen oder mehrmaligen) Kompensation des Offsetfehlers, wobei zumindest eine Offsetfehlerkompensation einer Skalierungsfehlererfassung oder auch Skalierungsfehlerkompensation vorausgehen. Dies entspricht der Auflösung eines linearen Gleichungssystems einer Gerade gemäß der GauB'schen Form. Alternativ kann jedoch anstatt einer stufenweisen Auflösung der beiden Fehlerarten auch eine andere Form gewählt werden, um ein Gleichungssystem einer Geraden mit zwei Gleichungen hinsichtlich Skalierungsfehler und Offsetfehler aufzulösen.

Der Offsetfehler wird vorzugsweise bestimmt für Zeitfenster, in denen die Relativladung bzw. der hierzu gemessene Strom bzw. dessen zeitliches Integral über das Zeitfenster im Wesentlichen Null ist. Relativladung und gemessener Strom sind zwei zueinander alternative oder in Kombination zu verwendende Größen, um den Belastungszustand abzuschätzen. Bei hoher Belastung kann der Skalierungsfehler gemessen werden, bei geringer (oder keiner) Belastung kann der Offsetfehler gemessen werden. Hohe Ladung bzw. hoher Strom (d.h. Werte, deren Betrag über einem Mindestwert liegt oder deren Betrag mindestens so groß wie der Mindestwert ist) entsprechen hoher Belastung, geringe oder keine Ladung bzw. Strom entsprechen geringer Belastung, wobei der Betrag der Strom- bzw. Ladungswerte unter bzw. nicht über einem Maximalwert liegt (der Maximalwert kann im wesentlichen 0 + ε) entsprechen). Die Bestimmung des Offsetfehlers geht vorzugsweise der Bestimmung des Skalierungsfehlers voraus. Bei einer vom Schätzer vorgesehenen, auf das Zeitfenster bezogenen Ladung wird erfindungsgemäß davon ausgegangen, dass der tatsächlich fließende Akkumulatorstrom im Wesentlichen Null ist. Als Offsetfehler wird hier der konstante (nicht stromabhängige) Unterschied zwischen einem tatsächlichen Stromfluss (Null oder unter einem Maximalwert) und einem gemessenen Strom (Null oder unter einem Maximalwert) bezeichnet, der dem Strommessungs-Offsetfehler entspricht. Dies gilt ebenso für geschätzte, auf das Zeitfenster bezogene Ladungen, deren Betrag unterhalb eines Offsetfehler-Schwellwerts ist. Vorzugsweise entspricht dieser Schwellwert nur einem geringen Teil eines Normbetrieb-Stromflusswertes, beispielsweise 1 %, ein Promille oder weniger. Bei einer geschätzten, auf ein Zeitfenster bezogenen Ladung von ungleich Null (jedoch unterhalb des Schwellwerts) kann diese Ladung auf die Länge des Zeitfensters normiert werden, und der Offsetfehler ergibt sich aus der Differenz zwischen der auf die Länge des Zeitfensters normierten geschätzten Ladung und dem erfassten, d.h. gemessenen Akkumulatorstrom. Wie bereits bemerkt, kann die geschätzte Ladung und der damit einhergehende Strom, der sich durch die Normierung der geschätzten Ladung auf die Länge des Zeitfensters ergibt, zu Null angenommen werden, so dass der Offsetfehler dem erfassten Akkumulatorstrom entspricht, oder umgekehrt. Der Vergleich der geschätzten Ladung mit dem Akkumulatorstrom kann somit als Stromvergleich ausgeführt werden, indem entweder die geschätzte Ladung zu Null angenommen wird oder die geschätzte Ladung auf die Länge des Zeitfensters normiert wird, bevor diese mit dem Akkumulatorstrom verglichen wird. Ferner kann der Vergleich der geschätzten Ladung mit dem erfassten Akkumulatorstrom vorgesehen werden als Ladungsvergleich, wobei die geschätzte Ladung mit dem erfassten Akkumulatorstrom verglichen wird, der durch Multiplikation mit der Länge des Zeitfensters auf das Zeitfenster bezogen wird. Die sich ergebende Differenz wird entweder als auf das Zeitfenster bezogene Offsetfehlerladung zur Kompensation verwendet oder zur Kompensation wiederum auf die Länge des Zeitfensters normiert, um einen Offsetfehler in der Form eines Stroms vorzusehen. Als Nulldurchgangszeitpunkt wird der Zeitpunkt bzw. das Zeitfenster bezeichnet, an dem die geschätzte Ladung im Wesentlichen Null beträgt und somit gleich Null angenommen wird, oder zu dem die geschätzte Ladung gering ist, und somit nur einen sehr geringen Anteil des Skalierungsfehlers mitumfasst. Der Nulldurchgangszeitpunkt bzw. das Zeitfenster, in dem dieser auftritt, kann durch Vergleichen der Ladung mit einer oberen und einer unteren Grenze vorgesehen werden, wobei die Grenzen um den Stromnullpunkt herum angeordnet sind, die ein Stromintervall definieren, dessen Betragsmaximum deutlich unter einem Norm-Stromwert oder deutlich unterhalb einem Maximal-Stromwert entspricht. Der Norm-Stromwert bezieht sich auf Norm-Betriebsparameter und der Maximal-Stromwert bezieht sich auf einen durch den Akkumulator und den Shunt-Widerstand vorgesehenen Maximal-Stromwert, wobei die Grenze zur Erfassung des Nulldurchgangszeitpunkts nur geringen Bruchteilen dieses Werts entspricht, beispielsweise 10⁻³, 10⁻⁴ oder 10⁻⁶. Der Vergleich der geschätzten Ladung zum Nulldurchgangszeitpunkt mit dem erfassten Akkumulatorstrom umfasst die Differenzbildung zwischen erfasstem Akkumulatorstrom und geschätzter Ladung sowie die Annahme, dass die geschätzte Ladung Null entspricht, und somit der erfasste Akkumulatorstrom dem Offsetfehler zugeordnet wird.

Der Skalierungsfehler wird hingegen bei einem Maximumszeitpunkt ermittelt, bei dem der Anteil des Offsetfehlers möglichst gering ist, wobei dies vorzugsweise dadurch vorgesehen wird, dass der Offsetfehlers vor Ermittlung des Skalierungsfehlers kompensiert wird, oder der Anteil des Offsetfehlers als vordefinierte Größe oder als gleich Null angenommen wird. Das Zeitfenster wird vorzugsweise derart gewählt, dass für ein Grossteil des Zeitfensters oder für das gesamte Zeitfenster der gemessene Strom oder die geschätzte, sich auf das Zeitfensters beziehende Relativladung einen hohen Wert aufweist, der über einem vorgegebenen Wert liegt. Das Zeitfenster kann hierzu beendet werden, wenn der gemessene Strom oder die geschätzte Ladung unter dem vorgegebenen Wert liegt. Ferner werden nur Zeitfenster verwendet, in denen kein Vorzeichenwechsel des gemessenen Stroms oder der geschätzten Ladung vorliegt. Das Zeitfenster überstreicht einen hohen Belastungszeitpunkt des Akkumulators, sei es hinsichtlich einer Entladung oder einer Aufladung. Der Maximumszeitpunkt bzw. das Zeitfenster, in dem dieser auftritt, bestimmt sich durch den Zeitpunkt eines relativen Maximums der geschätzten Ladung Qr, die auf das Zeitfenster bezogen wird, oder bezieht sich auf einen Zeitpunkt bzw. ein Zeitfenster, bei dem die geschätzte Ladung einen Wert größer als eine Mindestladungsdifferenz aufweist. Die Mindestladungsdifferenz, bezogen auf das Zeitfenster und somit formuliert als gemittelter Stromwert, der die geschätzte Relativladung wiedergibt, entspricht beispielsweise einem Normstrom oder einem hohen Anteil eines Normstrom- oder Maximalstromwerts, der von dem Akkumulator und dem Shunt-Widerstand vorgesehen wird. Erfindungsgemäß wird der Akkumulatorstrom ebenso anhand des Strommessungs-Skalierurgsfehlers kompensiert, beispielsweise durch Multiplikation des erfassten bzw. gemessenen Akkumulatorstroms mit dem Kehrwert des Skalierungsfehlers.

Der Offsetfehler und der Skalierungsfehler können nach ihrer Berechnung sofort vollständig zur Kompensation verwendet werden, d.h. vollständig durch Subtraktion (OffsetFehler) oder durch Multiplikation mit dem Kehrwert (Skalierungsfehler) zur Kompensation verwendet werden. Alternativ werden die Fehler jedoch vorzugsweise mit steigendem Anteil bei einer kontinuierlich ansteigenden Kompensation berücksichtigt. Zur kontinuierlich zunehmenden Kompensation wird vorzugsweise ein PI-Regler verwendet, wie im Weiteren näher beschrieben ist.

Das erfindungsgemäße Verfahren zur fehlerkompensierten Strommessung umfasst somit die Schritte des Anspruchs 1, die von entsprechenden Merkmalen einer erfindungsgemäßen Vorrichtung umgesetzt werden. Zur Erfassung dient somit ein Stromerfassungssensor, vorzugsweise ein Shunt-Widerstand oder auch ein Magnetsensor oder Hall-Sensor, dessen Fehler erfindungsgemäß linear durch Offsetfehler und Skalierungsfehler angenähert wird. Die Vorrichtung umfasst einen Stromsignaleingang, der in digitaler oder analoger Weise ein gemessenes Stromsignal von einer Messeinrichtung empfängt, beispielsweise von einem Stromerfassungssensor und dessen zugehöriger Signalaufbereitungssehaltung. Die Vorrichtung umfasst ferner einen Schätzer, der die auf ein Zeitfensters bezogene geschätzte Ladung basierend auf dem Modell des Schätzers vorsieht.

Das Modell bildet mehrere Zustände ab und entspricht als Nährung dem physikalischen Modell des Akkumulators. Das Modell bildet den Akkumulator auf Grund von mehreren Betriebsgrößen ab, wobei eine Betriebsgröße der Akkumulatorstrom ist und weitere Betriebsgrößen nicht oder nur mittelbar von dem Akkumulatorstrom abhängen und einen Einfluss auf den Zustand des vom Modell geschätzten Ladezustands haben. Derartige weitere Betriebsgrößen sind insbesondere die Klemmspannung, eine Leerlaufspannung, die innerhalb des Leerlaufs verwendet wird, ein Innenwiderstand, der innerhalb des Modells verwendet wird, Temperatur des Akkumulators und weiteres. Diese weiteren Betriebsgrößen können einzeln oder auch in beliebiger Kombination miteinander verwendet werden, zusammen mit dem Akkumulatorstrom. Das Modell ist ein SOC-(state of charge, Ladezustand)-Schätzer beispielsweise basierend auf einer Vielzahl von Diffusionsprozessen, die in Form von numerischen Näherungen wiedergegeben sind. Das Modell kann ferner Interpolation umfassen, um aus diskreten bekannten Betriebsparametern, die verschiedene diskreten Zustände betreffen, auf den zu schätzenden Akkumulatorzustand und insbesondere auf den Ladungszustand oder auf die geschätzte, auf das Zeitfenster bezogene Ladung zu bestimmen. Das Modell kann ferner mittels empirischer Daten, beispielsweise in Form von Tabellen, bereits verschiedene bekannte Zustände des Akkumulators anhand verschiedener Betriebsparameter wiedergeben, wobei durch Vergleich der aktuellen Betriebsparameter der nächstliegende Zustand ermittelt werden kann, gegebenenfalls unter Einsatz von Interpolation. Das Modell kann somit verschiedene Komplexitätsstufen aufweisen, beispielsweise in Form von komplexen Kalmanfiltern oder neuronalen Netzen, welche die Fundierungsprozesse implizit oder explizit im Detail wiedergeben, oder kann durch einfache Modelle wiedergegeben sein, die im Wesentlichen auf empirisch ermittelten Tabelleneinträgen basieren.

Zur Erfassung des Nulldurchgangs wird ein Nulldurchgangsvergleicher hervorgesehen, der ermittelt, ob die geschätzte Ladung im Wesentlichen Null entspricht oder der Betrag der geschätzten Ladung unter einem Schwellwert, d.h. einem Maximalwert liegt. Mit dem Nulldurchgangsvergleicher ist eine Offsetfehlerermittlungseinrichtung verbunden, die mit einer Subtraktionseinrichtung den Offsetfehler vorsieht. Die Subtraktionseinrichtung kann ferner auch aus einer einfachen Signalweiterleitung bestehen, wenn die geschätzte Ladung zu Null angenommen wird und somit die auf das Zeitfensters normierte geschätzte Ladung unmittelbar den Offsetfehler wiedergibt. Dies entspricht einer Subtraktion von Null von der normierten geschätzten Ladung. Ferner umfasst die erfindungsgemäße Vorrichtung einen Maximumsvergleicher, der ermittelt, ob die geschätzte Ladung (oder der gemessene Strom oder dessen Integral über das Zeitfenster) ausreichend groß ist (im Vergleich mit einer Mindestladungsdifferenz). Alternativ kann der Maximumsvergleicher geschätzte Ladung aufeinander folgender Zeitfenster miteinander vergleichen, um somit aufeinander folgende, vom Vorzeichen entgegengesetzte Steigungen zu erkennen, um daraus auf ein relatives Maximum des Betrags der geschätzten Ladung zu schließen. Somit können geschätzte Ladungen von zwei aufeinander folgenden Zeitfenster verglichen werden, um die Steigung festzustellen, wobei ein wiederholter Vergleich von zwei (weiteren) Zeitfenstern den Ort des relativen Maximums darstellt. Vorzugsweise werden unmittelbar aufeinander folgende Zeitfenster miteinander verglichen. Die Skalierumgsfehlerermittlungseinrichtung umfasst eine Offsetfehlerkompensationseinrichtung, die zunächst den ermittelten Strommessungs-Offsetfehler vom Akkumulatorstrom abzieht, beispielsweise bezogen auf einen (gemittelten) Strom oder bezogen auf das zeitliche Integral des geschätzten Akkumulatorstroms. Daraufhin wird durch eine Verhältniseinrichtung der Skalierungsfehler ermittelt durch Division des Akkumulatorstroms durch die auf die Länge des Zeitfensters normierte geschätzte Ladung. Alternativ kann auch der Kehrwert hiervon vorgesehen werden. Als weitere Alternative kann der mit der Länge des Zeitfensters multiplizierte Akkumulatorstrom oder der für die Länge des Zeitfensters integrierte Akkumulatorstrom mit der geschätzten Ladung verglichen werden, die sich auf das Zeitfenster bezieht.

Zur Kompensation wird der ermittelte Offsetfehler beispielsweise mit umgekehrten Vorzeichen zu dem (gemessenen) Akkumulatorstrom addiert und der Skalierungsfehler als sein Kehrwert mit dem Akkumulatorstrom multipliziert. Dies entspricht einer unmittelbaren Kompensation.

Alternativ kann jedoch auch ein Korrekturfehlergenerator vorgesehen sein, der einen Korrekturfehler erzeugt und den erfassten Akkumulatorstrom anhand des Korrekturfehlers korrigiert. Der Korrekturfehlergenerator kann einen PI~Regler umfassen, der den Korrekturfehler als rückgekoppelte Regelgröße führt, wobei als Sollvorgabe, deren Differenz zur Regelgröße zur integrativen Regelung verwendet wird, der Strommessungs-Offsetfehler ist. Anstatt des Offsetfehlers kann auch der Skalierungsfehler oder eine Summe des Offsetfehlers und des Skalierungsfehlers als Sollwert vorgegeben sein. In einer weiteren Ausführung umfasst die Vorrichtung zwei Korrekturfehlergeneratoren, wobei ein Korrekturfehlergenerator für den Offsetfehler verwendet wird, und ein weiterer Korrekturfehlergenerator für den Skalierungsfehler verwendet wird, wobei beide einen PI-Regler umfassen, der als Sollwert den Offsetfehler bzw. den Skalierungsfehler erhält und als Regelgröße den jeweiligen Korrekturfehler führt. Die Kompensation wird dann durchgeführt mittels Kombination der Korrekturfehler bzw. mittels einzelner Kompensation des Offsetfehlers und des Skalierungsfehlers anhand des zugehörigen Offsetfehler- oder Skalierungsfehler-Korrekturfehlers, um so die beiden Fehler kombiniert zu korrigieren. Der oder die PI-Regler sind Teil einer Kompensationseinrichtung der Vorrichtung, wobei jeder PI-Regler eine Verstärkerstufe (P), eine Integratorstufe (I), eine Fehlerbildungseinheit sowie einen Rückkopplungspfad umfasst.

Die Vorrichtung umfasst ferner vorzugsweise einen Zeitfenstergenerator, der Beginn und Ende des Zeitfensters vorgibt, wobei die Zeitfenster vorzugsweise unmittelbar aufeinander folgen, Um das Zeitfenster geeignet vorzusehen kann der Zeitfenstergenerator den gemessenen Strom oder die geschätzte Relativladung auswerten, ob die zur Erfassung des Offsetfehlers bzw. des Skalierungsfehlers notwendigen Voraussetzungen gegeben sind. Voraussetzung zur Erfassung des Skalierungsfehlers ist die Erfassung einer hohen Akkumulatorbelastung, und Voraussetzung zur Erfassung des Offsetfehlers ist die Erfassung einer geringen Akkumulatorbelastung. Eine hohe Akkumulatorbelastung wird beispielsweise erfasst durch Vergleich des gemessenen Stromwerts oder der geschätzten Relativladung- mit einem Mindestwert oder durch Erfassung relativer Minima dieser Größen, und eine geringe mittlere bzw. über das Zeitfenster integrierte oder aufsummierte Akkumulatorbelastung wird beispielsweise erfasst durch Vergleich des gemessenen Stromwerts oder der geschätzten Relativladung mit einem Maximalwert oder durch Erfassung eines Nulldurchgangs oder eines Werts, der im wesentlichen Null entspricht.

Die Vorrichtung umfasst ferner vorzugsweise einen Normierer, der auf die geschätzte Ladung auf die Länge der Zeitfenster durch die Vision normiert oder den Akkumulatorstrom durch Multiplikation die Länge des Zeitfensters auf das Zeitfenster bezieht. Zudem sind Komponenten der Vorrichtung mit dem Zeitfenstergenerator verbunden, um Beginn und Ende jedes Zeitfensters zu erfassen, um ein Zeitfenster, bei dem die auf das Zeitfenster bezogene Ladung deutlich von Null abweicht oder nicht ausreichend groß ist von der Ermittlung des Offsetfehlers bzw, von der Ermittlung des Skalierungsfehlers auszuschließen. Die Länge der Zeitfenster beträgt vorzugsweise 30 s -1800 s, 60 s - 1500 s, 100 s -1000 s oder 500 s - 900 s, wobei mittelbar oder unmittelbar aufeinander folgende Zeitfenster identische Längen haben können oder verschiedene Längen haben können. Beginn und Ende der Zeitfenster können gemäß den oben stehenden Yorraussetzungen zur Erfassung von Offset- und Skalierungsfehler gewählt werden. Dies gilt ebenso für die Schritte des erfindungsgemäßen Verfahrens. Die Zeitfenster können beispielsweise beendet werden, wenn nach der Erfassung eines Nulldurchgangszeitpunkts die geschätzte Ladung deutlich von Null abweicht oder nach der Erfassung eines Maximumszeitpunkts der Betrag der geschätzten Ladung unter eine Mindestladungsdifferenz fällt.

Zwischen Kompensation und Erfassung des Offsetfehlers, des Skalierungsfehlers oder beider Fehler können diese gemäß einer Temperatur bzw. einer Temperaturänderung kompensiert werden. Hierzu wird eine Temperaturfehlerkomponente für den Offsetfehler, für den Skalierungsfehler oder für beide Fehler in linearer Abhängigkeit von der Temperatur bzw. von einem Temperaturunterschied ermittelt. Die lineare Abhängigkeit ist vorbestimmt durch ein Temperaturverhalten zumindest einer Komponente der Messeinrichtung, beispielsweise abhängig von dem an eine Gerade angenähertem Temperaturverhalten des Widerstandwert des Shunt-Widerstands, des Offsetfehlers oder des Skalierungsfehlers der Pufferstufe (beispielsweise vorgesehen durch einen Operationsverstärker), durch den Skalierungsfehler auf Grund der Temperaturabhängigkeit eines Zeitgebers einer Sample- and Holdvorrichtung oder auf Grund des Temperaturdrifts einer Referenzsspannungsquelle eines A/D-Wandlers. Die Temperaturfehlerkomponente entspricht dem extrapolierten Temperaturfehler, der dem jeweiligen Fehler bzw. der Kombination der Fehler hinzugefügt wird, um bei Kompensation auch die Temperaturfehlerkomponente zu kompensieren. Als lineare Abhängigkeit werden erfindungsgemäß auch stückweise konstante Abhängigkeiten angesehen in Form von aufeinander folgenden Temperaturintervallen, während dem ein Temperaturfehlerkomponentenwert als konstant angesehen wird. Insbesondere dient die Kompensation der Temperaturabhängigkeit des Strommessungs-Offsetfehlers. Die Kompensation kann beispielsweise mittels eines Interpolators der erfindungsgemäßen Vorrichtung vorgesehen werden, der aus Temperaturen des Stromerfassungssensors oder anderen Komponenten der Strommessvorrichtung eine Temperaturfehlerkomponente durch Interpolation vorsieht. Die Temperaturabhängigkeit kann wiedergeben sein durch eine Steigung oder Steigungsgerade, die eine lineare Abhängigkeit widerspiegeln. Grundsätzlich können jedoch auch Näherungen höherer Ordnung zur Ermittlung der Temperaturfehlerkomponente verwendet werden. Die Näherungen können als diskrete Werte bzw. Werteintervalle wiedergeben sein, wobei Stützstellen den Verlauf durch Interpolation definieren. Es können hierzu Tabellen verwendet werden, vorzugsweise einschließlich einer zugehörigen Interpolation. Ferner kann die Temperaturabhängigkeit als Näherungsformel realisiert sein, deren Parameter das Materialverhalten in einer kontinuierlichen Abhängigkeit wiedergeben, wobei die Näherungsformel eine lineare Abhängigkeit oder auch Abhängigkeiten höherer Ordnung wiedergibt.

Als Temperatur wird vorzugsweise die an dem Shunt-Widerstand erfasste Temperatur vierwendet, wobei alternativ auch die Temperatur des Akkumulators oder der an dem Shunt-Widerstand angeschlossenen Messsigmalaufbereitungsschaltung verwendet werden. Hierzu können zusätzliche Temperatursensoren verwendet werden, oder es kann ein Temperatursensor des Akkumulators verwendet werden. Der Temperaturkompensation zu Grunde gelegt wird eine Temperaturdifferenz zwischen einer Temperatur, die während dem Zeitfenster erfasst wurde, und einer Temperatur, die während der Kompensation herrscht. Die Vorrichtung umfasst somit ferner vorzugsweise einen Speicher, der Temperaturwerte, die wie oben beschrieben erhalten werden, speichert. Der gleiche Speicher oder ein weiterer Speicher kann dazu verwendet werden, um den Strommessungs-Offsetfehler zu speichern, zumindest bis ein Maximumszeitpunkt aufgetreten ist, an dem bei der Ermittlung des Skalierungsfehlers und der zugehörigen Kompensation auf den vorher erfassten Offsetfehler zugegriffen werden kann.

Das erfindungsgemäße Verfahren umfasst vorzugsweise ferner den Schritt des Ermittelns des Ist-Ladezustands des Akkumulators als zeitliches Integral oder als laufende Summe des kompensierten Akkumulatorstroms oder als laufende Summe der geschätzten Ladung oder als Kombination hiervon. In gleicher Weise umfasst die Vorrichtung vorzugsweise einen Integrator oder einen Summierer, der als Resultat den Ist-Ladezustand des Akkumulators ausgibt und den kompensierten gemessenen Akkumulatorstrom oder die geschätzte Ladung oder eine Kombination hiervon erhält.

Die Vorrichtung wird vorzugsweise umgesetzt durch eine programmierbare Schaltung, bei der Softwareeinzelkomponenten der Vorrichtung, zusammen mit der Verarbeitungshardware, vorsieht. Alternativ können einzelne oder alle Komponenten der Vorrichtung als Schaltung aufgebaut sein.

### Kurze Beschreibung der Zeichnungen

Ausrührungsbeispiele der Erfindung sind in den Zeichnungen dargestellt und in der nachfolgenden Beschreibung näher erläutert.

Es zeigen
- Figur 1: Eine Akkumulatorstrom-Messeinrichtung zur Ausführung der Erfindung; und
- Figur 2: Ein Schaltbild der erfindungsgemäßen Vorrichtung zur näheren Erläuterung des erfindungsgemäßen Verfahrens.

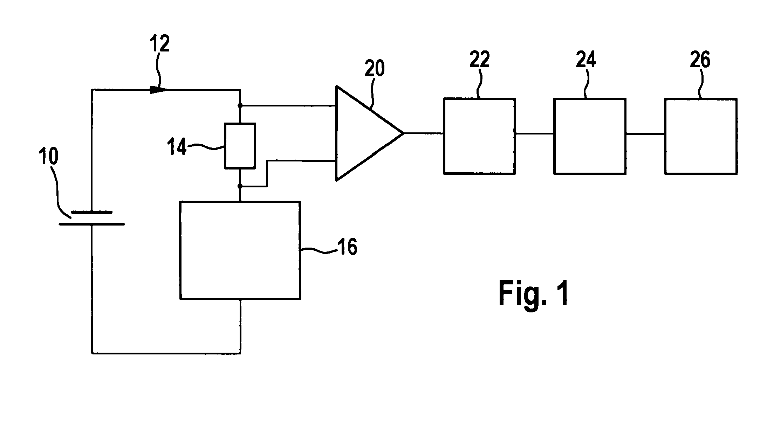

Die Figur 1 zeigt einen Akkumulator 10 der Strom 12 erzeugt, der durch einen Shunt-Widerstand 14 und einen Verbraucher 16 läuft. Akkumulator 10, Shunt-Widerstand 12 und Verbraucher 16 bilden einen geschlossenen Stromkreis. Anstatt des Shunt-Widerstands 10 kann auch eine durchgehende Leitung verwendet werden, wobei ein Hall-Sensor oder ein anderer Magnetsensor das vom Strom 12 erzeugte Magnetfeld erfasst und daraus den Strom 12 ableitet. Die am Shunt-Widerstand 14 abfallende Spannung wird einer Pufferschaltung 20 zugeführt, die einen hohen Innenwiderstand hat und gegebenenfalls das Spannungssignal verstärkt. Der Ausgang der Pufferschaltung ist mit einer Sample&Hold-Stufe 22 verbunden, die den von der Pufferschaltung 20 abgegebenen analogen Wert abtastet und hält, diesen an einen A/D-Wandler 24 weiterleitet, der aus dem analogen Signal einen digitalen Wert erzeugt, der dem Mikrocontroller 26 zur weiteren Verwertung zugeführt wird. Die Elemente 20, 22, 24 und gegebenenfalls auch 26 sind Elemente einer Signalaufbereitungsschaltung, die jeweils Fehler in die Messung mit einbringen. So umfasst die Pufferschaltung einen Operationsverstärker mit einem Offsetfehler (und gegebenenfalls auch einem Skalierungsfehler) der A/D-Wandler 24 umfasst eine Referenzspannungsquelle, beispielsweise einen Referenzspannungshalbleiter, der bei Temperaturänderungen einen Skalierungsfehler aufweist, wobei auch die Sample&Hold-Stufe 22 gegebenenfalls einen Offsetfehler oder Skalierungsfehler mit einbringen kann. Neben der Temperaturabhängigkeit können sich Offsetfehler und Skalierungsfehler durch Bauteiltoleranzen ergeben, beispielsweise durch eine Toleranz von 5 % oder 3 % des Shunt-Widerstands. Weitere Fehler ergeben sich durch Temperaturdifferenz zwischen Herstellung und Einsatzort, wobei bei der Herstellung gegebenenfalls das System kalibriert wurde oder zumindest einen geringen Fehler aufweist und am Einsatzort, beispielsweise im Motorraum eines Kraftfahrzeugs eine höhere Temperatur herrscht, die weitere Fehler erzeugt.

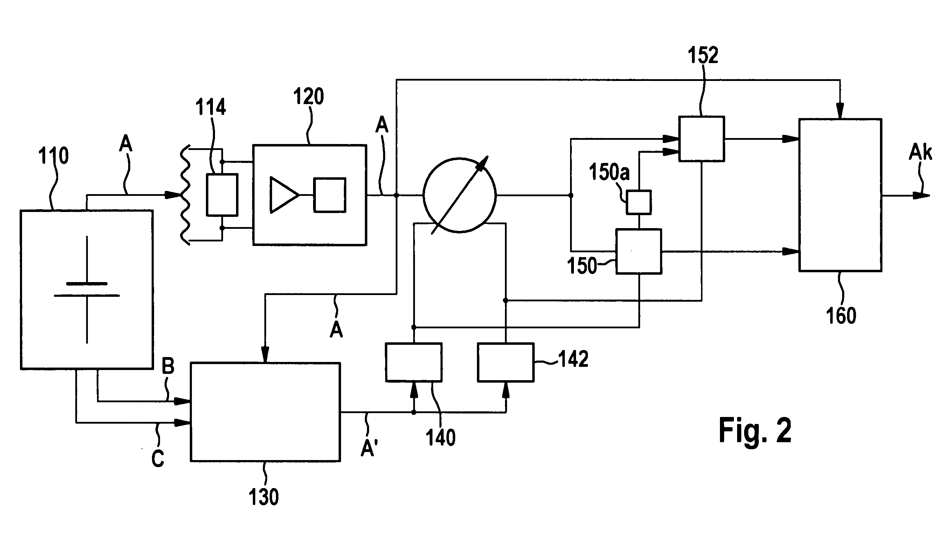

Die Figur 2 zeigt eine erfindungsgemäße Vorrichtung, zusammen mit einem Akkumulator 110 der Betriebsparameter aufweist, die an einen Shunt-Widerstand 114 und einen Schätzer 130 übertragen werden. Die Betriebsparameter des Akkumulators sind als A, B und C bezeichnet, da diese (bis auf Akkumulatorstrom und Klemmenspannung) im wesentlichen austauschbar sind, sofern sie mit dem Ladungszustand des Akkumulators korreheren. Die Betriebsgrößen in Figur 2 sind Akkumulatorstrom A, Temperatur B sowie Klemmspannung C. Der Strom A wird vom Shunt-Widerstand und einer daran angeschlossenen Signalaufbereitungsschaltung 120 und in aufbereiteter Form dem Schätzer 130 zugeführt. Somit umfasst die Vorrichtung zwei Linien zur Ermittlung des Akkumulatorstroms: die auf Messung beruhende Linie 114, 120, die einen fehlerbehafteten Messstrom erzeugt, sowie die Linie des Schätzers 130, der auf Grund des gemessenen Stroms A und weiterer Betriebsparameter B, C einen Zustand schätzt, aus dem dieser eine geschätzte Ladung A' ableitet. Die geschätzte Ladung A' bezieht sich auf ein bestimmtes Zeitintervall und ist somit, wie auch die physikalische Einheit Strom, auf Zeit bezogen. Aus diesem Grund wird der gemessene momentane Strom A ähnlich bezeichnet wie die geschätzte Ladung A'. Anstatt der Bezeichnung A wird auch die Bezeichnung Qr verwendet, um eine relative Ladung (Qr) zu bezeichnen, und anstatt der Bezeichnung A' wird der Akkumulatorstrom mit Im bezeichnet, der für einen gemessenen Strom (I) steht. Der Schätzer 130 gibt somit eine geschätzte Ladung Qr aus und übermittelt diese an daran angeschlossene Vergleicher 140, 142. Der Vergleicher 140 ermittelt als Nulldurchgangsvergleicher, ob die geschätzte Ladung A' (Qr) im Wesentlichen Null ist (oder, alternativ, vom Betrag her unter einem Maximalwert liegt). Der Vergleicher 140 vergleicht somit mit Null oder mit Intervallgrenzen, die ein schmales Intervall um den Nullpunkt herum definieren. Der Nulldurchgangsvergleicher ermittelt hierdurch eine Nulldurchgangszeit. In gleicher Weise vergleicht der Vergleicher 142, der einen Maximumsvergleicher darstellt, den Betrag der geschätzten Ladung A' (Qr) mit einer Mindestladungsdifferenz oder erfasst in einer weiteren Ausführung das relative Maximum der zeitfensterbezogenen geschätzten Ladung A' durch Vergleich von geschätzten Ladungen verschiedener Zeitfenster. Der Maximumsvergleicher 142 kann ferner auch beide Vergleiche durchführen und erst dann ausgeben, dass ein Maximum auftritt, wenn zum einen ein relatives Maximum vom Vergleicher 142 erkannt wurde und zum anderen der Wert dieses Maximums der geschätzten Ladung über einer Mindestladungsdifferenz liegt. Die Mindestladungsdifferenz bietet somit einen Schwellwert für die geschätzte Ladung, der angibt, dass die geschätzte Ladung ausreichend groß zur Skalierungsfehlererfassung ist, wobei die Mindestladungsdifferenz eine Differenz zwischen verschiedenen Gesamtladungszuständen des Akkumulators darstellt.

Der Vergleicher 140 und der Vergleicher 142 ist jeweils mit einer symbolisch dargestellten Messwerterfassung verbunden, die bei Kennzeichnung des Nulldurchgangszeitpunkts und bei Kennzeichnung des Zeitpunkts der Skalierungsfehlererfassung den jeweiligen Wert der geschätzten Ladung ermittelt. Diese werden an eine Offsetfehlerermittlungseirnichtung 150 bzw. an eine Skalierungsfehlerermittlungseinrichtung 152 übertragen, um den jeweiligen Fehler zu berechnen und somit eine Kompensation zu ermöglichen. Zunächst ermittelt die Einrichtung 150 den Offsetfehler, legt diesen beispielsweise in einem Speicher 150a ab, der der Offsetfehlerermittlungseinrichung 150 zugeordnet ist. Trifft zu einem späteren Zeitpunkt ein Zeitpunkt zur Skalierungsfehlererfassung auf, so erzeugt die Einrichtung 152 basierend auf dem im Speicher 150a abgelegten Skalierungsfehler und der geschätzten Ladung zum Zeitpunkt der Skalierungsfehlererfassung den Skalierungsfehler.

Der Zeitpunkt der Skalierungsfehlererfassung entspricht dem Zeitpunkt, an dem der Maximumsvergleicher eine ausreichend große geschätzte Ladung ermittelt oder ein relatives Maximum des Betrags der geschätzten Ladung ermittelt (oder beides), wobei der Zeitpunkt der Skalierungsfehlererfassung gleichbedeutend ist mit dem Zeitfenster, in dem die ausreichend große geschätzte Ladung, das relative Maximum der geschätzten Ladung oder beides auftritt. In gleicher Weise entspricht der Nulldurchgangszeitpunkt dem Zeitfenster, in dem dieser auftritt. Der zugehörige Betrag ist der Mittelwert der geschätzten Ladung für das gesamte Zeitfenster oder, falls nur ein Ladungswert geschätzt wird während dieses Zeitfensters, dem geschätzten Ladungswert, der dem Zeitfenster zugeordnet ist.

Schließlich umfasst die Vorrichtung von Figur 2 ein Kompensationseinrichtung 160, die den gemessenen Akkumulatorstrom A (Im) empfängt sowie den Skalierungsfehler sowie den Offsetfehler von den Einrichtungen 150 und 152. Auf Grund der bekannten Fehler kompensiert die Kompensationseinrichtung 160 den gemessenen Strom A (Im) und gibt den kompensierten gemessenen Stromwert Ak aus.

Im Falle einer weitergehenden Temperaturkompensation ist die Kompensationseinrichtung 160 mit Temperatursensoren des Akkumulators 110, des Shunt-Widerstands 114 (bzw. des Stromsensors 114) und der Signalvorverarbeitungsschaltung 120 verbunden, um bei Temperaturerhöhungen zusätzliche Temperaturfehlerkomponenten des Offsetfehlers und des Skalierungsfehlers zu ermitteln. Die somit ermittelten Temperaturfehlerkomponenten werden mit dem Offsetfehler bzw. mit dem Skalierungsfehler kombiniert, wobei die Fehlerkompensation anhand der kombinierten Fehler ausgeführt wird. In einer alternativen Ausführung wird zunächst der direkt ermittelte Offsetfehler und Skalierungsfehler kompensiert, wobei in einer darauf folgenden Stufe oder einer vorhergehenden Stufe die zugehörigen Temperaturfehlerkomponenten bei der Kompensation berücksichtigt werden. Um die verschiedenen Temperaturen den zugehörigen Zeitfenstern zuzuordnen, umfasst die Kompensationseinrichtung 160 ferner vorzugsweise einen Zeitsignaleingang, der Zeitsignale angibt, die zur Zuordnung von ermittelten Skalierungsfehlern oder Offsetfehlem zu jeweiligen Temperaturen (zur gleichen Zeit) ermöglichen.

Die in Figur 2 dargestellten Leitungen entsprechen Signalübertragungsverbindungen, die im Fall einer Softwareimplementierung durch entsprechende Prozedur oder Funktionsköpfe und deren Übergabevariablen realisiert werden. Die Pfeile geben die Richtung des Informationsflusses bzw. des Signalflusses an. Bis auf die Verbindung zwischen Akkumulator 110 und Shunt-Widerstand 114 übertragen sämtliche Verbindungen Signale, die Werte von physikalischen Größen wiedergeben.

Die erfindungsgemäße Vorrichtung umfasst optional einen mit dem Stromsignaleingang verbundenen Integrator, der zur Integration des Akkumulatorstroms (Im) für die Dauer des Zeitfensters eingerichtet ist, um den Vergleich mit der Relativladung des Schätzer auf der Basis eines Ladungsvergleichs auszuführen. Zudem kann die Vorrichtung einen Zeitnormierer umfassen, der auf das Zeitfenster bezogene Ladung (sei es vom Schätzer oder vom Integrator) auf eine sich von dem Zeitfenster unterscheidende Einheitszeitbasis zu übertragen, beispielsweise auf 1 Sekunde, um so den Vergleich zwischen Schätzung und Messung auf der Basis der Einheit Ampere durchzuführen.

## Patentansprüche

1. Verfahren zur fehlerkompensierten Strommessung eines elektrischen Akkumulators, mit den Schritten:
Vorsehen einer auf ein Zeitfenster bezogenen geschätzten Ladung (Qr), die von einem modellbasierten Schätzer aus Betriebsgrößen des Akkumulators ermittelt wird, und die die geschätzte Ladung wiedergibt, welche innerhalb des Zeitfensters von dem Akkumulator abgeflossen ist und dem Akkumulator zugeführt wurde;
Erfassen des während des Zeitfensters dem Akkumulator zugeführten und dem von dem Akkumulator abfließenden Akkumulatorstroms (Im) mit einem Stromerfassungssensor;
Erfassen eines Nulldurchgangszeitpunkts, an dem der Betrag der geschätzten Ladung (Qr) oder der Akkumulatorstrom (Im) kleiner als ein Maximalwert ist;
Erfassen eines Maximumszeitpunkts, zu dem der Betrag der geschätzten Ladung (Qr) oder der Akkumulatorstrom (Im) im wesentlichen ein relatives Maximum aufweist oder einen Wert aufweist, der größer als ein Mindestwert ist;
Ermitteln eines Strommessungs-Offsetfehlers zum Nulldurchgangszeitpunkt durch Vergleichen der geschätzten Ladung (Qr) mit dem erfassten Akkumulatorstrom (Im),
sowie Kompensieren des Akkumulatorstroms (Im) gemäß dem Strommessungs-Offsetfehler; und
Ermitteln eines Strommessungs-Skalierungsfehlers zum Maximumszeitpunkt durch Vergleichen der geschätzten Ladung (Qr) mit dem erfassten Akkumulatorstrom (Im);
und Abziehen des ermittelten Strommessungs-Offsetfehlers vom so erhaltenen Vergleichsergebnis; sowie Kompensieren des Akkumulatorstroms (Im) anhand des Strommessungs-Skalierungsfehlers.

2. Verfahren nach Anspruch 1, wobei das Vorsehen der geschätzten Ladung (Qr) umfasst: Ermitteln der geschätzten Ladung (Qr) mit einem Schätzer, der ein physikalisches Modell des Akkumulators umfasst, wobei die Betriebsgrößen des Akkumulators umfassen: den Akkumulatorstrom (Im) und zumindest eine weitere Betriebsgröße des Akkumulators, die nicht unmittelbar von dem erfassten Akkumulatorstrom (Im) abhängt, und die die geschätzten Ladung (Qr) beeinflusst, wobei die zumindest eine weitere Betriebsgröße umfasst: eine Akkumulatorklemmenspannung, eine Akkumulatortemperatur, zumindest eine weitere, sich vom Akkumulatorstrom (Im) unterscheidende Betriebsgröße des Akkumulators oder eine Kombination hiervon.

3. Verfahren nach Anspruch 1 oder 2, wobei das Kompensieren des Strommessungs-Skalierungsfehlers, das Kompensieren des Strommessungs-Offsetfehlers, oder beides umfasst: Erfassen einer Temperatur des Stromerfassungssensors oder einer Temperatur einer an den Stromerfassungssensor angeschlossenen Akkumulatorstrom-Messeinrichtung; Ermitteln einer Temperaturfehlerkomponente für den Strommessungs-Offsetfehler und für den Strommessungs-Skalierungsfehler in linearer Abhängigkeit von der Temperatur, wobei die lineare Abhängigkeit vorbestimmt ist durch ein Temperaturverhalten zumindest einer Komponente der Akkumulatorstrom-Messeinrichtung, die den Stromerfassungssensor umfasst, und die den Akkumulatorstrom (Im) erfasst; und Hinzufügen der jeweiligen Temperaturfehlerkomponente zu dem Strommessungs-Offsetfehler und zu dem Strommessungs-Skalierungsfehler.

4. Verfahren nach einem der vorangehenden Ansprüche, wobei das Kompensieren umfasst: Abziehen des Strommessungs-Offsetfehlers, des Strommessungs-Skalierungsfehlers oder beider Fehler von dem Akkumulatorstrom (Im); Multiplizieren eines Kehrwerts des Strommessungs-Offsetfehlers, eines Kehrwerts des Strommessungs-Skalienrungsfehlers oder eines Kehrwerts beider Fehler von dem Akkumulatorstrom (Im); oder Vorsehen eines Korrekturfehlers, anhand dem der erfasste Akkumulatorstroms (Im) korrigiert wird, wobei der Korrekturfehler als eine Regelgröße eines PI-Reglers geführt wird, der als Sollwert den Strommessungs-Offsetfehler, den Strommessungs-Skalierungsfehler oder eine Summe hiervon aufweist, um den Korrekturfehler gemäß dem Regelverhalten des PI-Reglers kontinuierlich an den Strommessungs-Offsetfehler, den Strommessungs-Skalierungsfehlers oder an eine Kombination beider Fehler heranzuführen, wobei der Akkumulatorstrom (Im) gemäß dem vom PI-Regler vorgesehenen Korrekturfehler korrigiert wird.

5. Verwahren nach einem der vorangehenden Ansprüche, wobei das Vorsehen der geschätzte Ladung (Qr) umfasst: Vorsehen des Zeitfensters als eines einer Vielzahl von aufeinander folgenden oder aneinander grenzenden Zeitfenstem, wobei entweder alle Zeitfenster eine zugehörige Länge aufweisen und die geschätzte Ladung (Qr) auf die zugehörige Länge normiert werden oder nicht normiert werden, oder Zeitfenster der Vielzahl von Zeitfenstern verschiedenen Längen und die geschätzte Ladung (Qr) auf die jeweilige Länge des zugehörigen Zeitfensters Länge normiert werden, und ferner während des gesamten Zeitfensters entweder die geschätzte Ladung (Qr) oder der gemessene Akkumulatorstrom (Im) im wesentlichen Null beträgt, der Betrag der geschätzten Ladung (Qr) oder der gemessene Akkumulatorstrom (Im) im wesentlichen ein relatives Maximum aufweist oder einen Wert aufweist, der größer als ein Mindestwert ist, oder die mit dem Zeitfenster verknüpfte geschätzte Ladung (Qr) weder zum Ermitteln des Strommessungs-Offsetfehlers noch zum Ermitteln des Strommessungs-Skalierungsfehlers verwendet wird.

6. Vorrichtung zur fehlerkompensierten Strommessung eines elektrischen Akkumulators (110), umfassend:
einen Stromsignaleingang, der zum Anschluss an eine Akkumulatorstrom-Messeinrichtung (114, 120) eingerichtet ist, die ein Stromsignal abgibt, das den Akkumulatorstrom (Im) während des Zeitfensters repräsentiert, der dem Akkumulator (110) zugeführt wird und von dem Akkumulator (110) abfließt;
einen Betriebsgrößeneingang für zumindest eine Betriebsgröße des Akkumulators;
einen modellbasierten Schätzer (130), der eingerichtet ist, eine auf ein Zeitfenster bezogene geschätzte Ladung (Qr) vorzusehen, und der mit dem Betriebsgrößeneingang verbunden ist; einen mit dem Schätzer (130) verbundenen Nulldurchgangsvergleicher (140), der die geschätzte Ladung (Qr) oder den Akkumulatorstrom (Im) mit einem Maximalwert vergleicht, um einen Nulldurchgangszeitpunkt zu ermitteln;
einen mit dem Schätzer verbundenen Maximumsvergleicher (142), der den Betrag der geschätzten Ladung (Qr) oder den Akkumulatorstrom (Im) mit einem Mindestwert vergleicht, oder der geschätzte Ladungen (Qr) oder erfasste Akkumulatorströme (Im) von zwei, drei oder mehr als drei aufeinander folgenden Zeitfenster miteinander vergleicht, um anhand der Differenz einen Zeitpunkt einer Skalierungsfehlererfassung zu erfassen;
eine Offsetfehlerermittlungseinrichtung (150), die eine Offsetsubtraktionseinrichtung umfasst, welche eingerichtet ist, die vom Schätzer vorgesehene geschätzte Ladung (Qr) von dem Akkumulatorstrom (Im) zum Nulldurchgangszeitpunkt, der von dem Nulldurchgangsvergleicher (140) vorgesehen wird, zu subtrahieren, um den Strommessungs-Offsetfehler als Ergebnis der Subtraktion vorzusehen;
eine Skalierungsfehlerermittlungseinrichtung (152), die eine Offsetfehlersubtraktionseinrichtung umfasst, welche eingerichtet ist, den von der Offsetfehlerermittlungseinrichtung vorgesehenen Strommessungs-Offsetfehler vom Akkumulatorstrom (Im) oder vom zeitlichen Integral des Akkumulatorstroms (Im) abzuziehen, um den Offsetfehler des Akkumulatorstroms (Im) zu kompensieren, wobei die Skalierungsfehlerermittlungseinrichtung ferner eine Verhältniseinrichtung umfasst, die zum Vorsehen eines Verhältnisses des kompensierten Akkumulatorstroms (m) zu der geschätzten Ladung (Qr) als Skalierungsfehler eingerichtet ist; sowie
eine Kompensationseinrichtung (160), die zur Kompensation des vorgesehenen Offsetfehlers des Akkumulatorstrom (Im), sowie zu Kompensation des Skalierungsfehlers des Akkumulatorstroms, der hinsichtlich des Offsetfehlers kompensiert wurde, eingerichtet ist.

7. Vorrichtung nach Anspruch 6, wobei der Schätzer (130) ein physikalisches Modell des Akkumulators (110) umfasst, wobei der Betriebsgrößeneingang eingerichtet ist, eine Akkumulatorklemmenspannung, eine Akkumulatortemperatur, zumindest eine weitere, sich vom Akkumulatorstrom (Im) unterscheidende Betriebsgröße des Akkumulators oder eine Kombination hiervon zu empfangen, wobei die Betriebsgröße nicht unmittelbar von dem erfassten Akkumulatorstrom (Im) abhängt, und die die geschätzten Ladung (Qr) beeinflusst.

8. Vorrichtung nach Anspruch 6 oder 7, die ferner einen Interpolator sowie einen damit verbundenen Temperatureingang für Temperaturen des Stromerfassungssensors oder einer an den Stromerfassungssensor angeschlossenen Akkumulatorstrom-Messeinrichtung (114, 120), wobei der Interpolator eine Temperaturfehlerkomponente des vorgesehenen Offsetfehler, des vorgesehenen Skalierungsfehler oder beider Fehler gemäß einem vorbestimmten, vom Interpolator vorgesehenen linearen Temperaturverhalten zumindest einer Komponente der Akkumulatorstrom-Messeinrichtung, die den Stromerfassungssensor umfasst, interpoliert, wobei der Interpolator eingerichtet ist, die jeweilige Temperaturfehlerkomponente dem Strommessungs-Offsetfehler, dem Strommessungs-Skalierungsfehler oder beiden Fehlern zur zusätzlichen Temperaturkompensation hinzuzufügen.

9. Vorrichtung nach einem der Ansprüche 6 - 8, wobei die Kompensationseinrichtung (160) umfasst: eine Subtraktionseinrichtung eingerichtet zum Abziehen des Strommessungs-Offsetfehlers, des Strommessungs-Skalierungsfehlers oder beider Fehler von dem Akkumulatorstrom (Im); eine Multiplikationseinrichtung eingerichtet zum Multiplizieren eines Kehrwerts des Strommessungs-Offsetfehlers, eines Kehrwerts des Strommessungs-Skalierungsfehlers oder eines Kehrwerts beider Fehler von dem Akkumulatorstrom (Im); oder einen Korrekturfehlergenerator eingerichtet zum Erzeugen eines Korrekturfehlers und eingerichtet zum Korrigieren des erfasste Akkumulatorstroms (Im) anhand des Korrekturfehlers, wobei der Korrekturfehlergenerator einen PI-Regler umfasst, der den Korrekturfehler als eine Regelgröße führt, und der PI-Regler als Sollwert den Strommessungs-Offsetfehler, den Strommessungs-Skalierungsfehler oder eine Summe hiervon erhält, und ein Regelverhalten aufweist, gemäß dem der Korrekturfehler kontinuierlich an den Strommessungs-Offsetfehler, an den Strommessungs-Skalierungsfehlers oder an eine Kombination beider Fehler herangeführt wird, und die Kompensationseinrichtung ferner eingerichtet ist, den Akkumulatorstrom (Im) gemäß dem Korrekturfehlergenerator vorgesehenen Korrekturfehler zu korrigieren.

10. Vorrichtung nach einem der Ansprüche 6 - 9, die ferner umfasst: einen Zeitfenstergenerator, der einen Beginn und ein Ende des Zeitfensters festlegt, wobei der Beginn eines darauf folgenden Zeitfensters mit dem Ende des vorhergehenden Zeitintervalls zusammenfallt oder danach folgt und alle Zeitfenster gleich lang sind oder unterschiedlich lang sind, und die Vorrichtung ferner einen Normierer umfasst, der bei gleich langen Zeitfenstern eingerichtet ist, die geschätzte Ladung (Qr) auf die Länge des Zeitfensters oder auf 1 zu normieren, und bei unterschiedlich langen Zeitfenstern eingerichtet ist, die geschätzte Ladung (Qr) auf die Länge des Zeitfensters zu normieren, wobei der Zeitfenstergenerator eingerichtet ist, wobei die Offsetfehlerermittlungseinrichtung, die Skalierungsermittlungseinrichtung, die Kompensationseinrichtung oder eine Kombination hiervon mit dem Zeitfenstergenerator verbunden sind und nur dann den Offsetfehler ermitteln, abziehen oder kompensieren, wenn der Nulldurchgangsvergleicher (140) für die gesamte Dauer des Zeitfensters der Betrag der geschätzten Ladung (Qr) oder des Akkumulatorstroms (Im) unter einem Maximalwert ermittelt, oder die Skalierungsfehlerermittlungseinrichtung (152), die Kompensationseinrichtung (160) oder beide mit dem Zeitfenstergenerator verbunden sind und nur dann den Skalierungsfehler ermitteln oder kompensieren, wenn der Maximumsvergleicher (142) für die gesamte Dauer des Zeitfensters einen Betrag der geschätzten Ladung (Qr) oder des Akkumulatorstroms (Im) oberhalb dem vorgesehenen Mindestwert ermittelt, oder wenn der Zeitpunkt der Skalierungsfehlererfassung innerhalb des Zeitfensters liegt.

## Claims

1. Method for error-compensated current measurement of an electrical rechargeable battery, comprising the steps of:
providing a time-window-related estimated charge (Qr), which is determined by a model-based estimator from operating parameters of the rechargeable battery and which reflects the estimated charge which is drawn from the rechargeable battery and has been supplied to the rechargeable battery during the time window;
detecting the rechargeable battery current (Im) which is supplied to the rechargeable battery and is drawn from the rechargeable battery during the time window using a current detection sensor;
detecting a zero crossing time, at which the magnitude of the estimated charge (Qr) or of the rechargeable battery current (Im) is less than a maximum value;
detecting a maximum time, at which the magnitude of the estimated charge (Qr) or the rechargeable battery current (Im) substantially has a relative maximum or has a value which is greater than a minimum value;
determining a current measurement offset error at the zero crossing time by comparing the estimated charge (Qr) with the detected rechargeable battery current (Im), and compensating for the rechargeable battery current (Im) according to the current measurement offset error; and
determining a current measurement scaling error at the maximum time by comparing the estimated charge (Qr) with the detected rechargeable battery current (Im);
and subtracting the determined current measurement offset error from the comparison result obtained in this way; and compensating for the rechargeable battery current (Im) on the basis of the current measurement scaling error.

2. Method according to Claim 1, wherein providing the estimated charge (Qr) comprises: determining the estimated charge (Qr) using an estimator which comprises a physical model of the rechargeable battery, wherein the operating variables of the rechargeable battery comprise: the rechargeable battery current (Im) and at least one further operating variable of the rechargeable battery which is not directly dependent on the detected rechargeable battery current (Im) and which influences the estimated charge (Qr), wherein the at least one further operating variable comprises: a rechargeable battery terminal voltage, a rechargeable battery temperature, at least one further operating variable of the rechargeable battery which differs from the rechargeable battery current (Im), or a combination of these.

3. Method according to Claim 1 or 2, wherein compensating the current measurement scaling error, compensating the current measurement offset error or both comprises: detecting a temperature of the current detection sensor or a temperature of a rechargeable battery current measuring device which is connected to the current detection sensor; determining a temperature error component for the current measurement offset error and for the current measurement scaling error in linear dependence on the temperature, wherein the linear dependence is predetermined by a temperature response of at least one component of the rechargeable battery current measuring device which comprises the current detection sensor, and which detects the rechargeable battery current (Im); and adding the respective temperature error component to the current measurement offset error and to the current measurement scaling error.

4. Method according to one of the preceding claims, wherein compensation comprises: subtracting the current measurement offset error, the current measurement scaling error or both errors from the rechargeable battery current (Im); multiplying an inverse value of the current measurement offset error, an inverse value of the current measurement scaling error or an inverse value of both errors by the rechargeable battery current (Im); or providing a correction error, on the basis of which the detected rechargeable battery current (Im) is corrected, wherein the correction error is controlled as a control variable of a PI controller which has the current measurement offset error, the current measurement scaling error or a sum of these as a setpoint value in order to approximate the correction error according to the control response of the PI controller continuously to the current measurement offset error, the current measurement scaling error or to a combination of both errors, wherein the rechargeable battery current (Im) is corrected according to the correction error which is provided by the PI controller.

5. Method according to one of the preceding claims, wherein providing the estimated charge (Qr) comprises:
providing the time window as one of a large number of successive or consecutive time windows, wherein either all of the time windows have an associated length and the estimated charge (Qr) is standardized to the associated length or is not standardized, or time windows of the large number of time windows have different lengths and the estimated charge (Qr) is standardized to the respective length of the associated time window, and furthermore, during the entire time window, either the estimated charge (Qr) or the measured rechargeable battery current (Im) is substantially zero, the magnitude of the estimated charge (Qr) or the measured rechargeable battery current (Im) substantially has a relative maximum or has a value which is greater than a minimum value, or the estimated charge (Qr) which is linked to the time window is not used either to determine the current measurement offset error or to determine the current measurement scaling error.

6. Apparatus for error-compensated current measurement of an electrical rechargeable battery (110), comprising:
a current signal input which is designed to be connected to a rechargeable battery current measuring device (114, 120) which outputs a current signal which represents the rechargeable battery current (Im) during the time window, which rechargeable battery current is supplied to the rechargeable battery (110) and is drawn from the rechargeable battery (110);
an operating variable input for at least one operating variable of the rechargeable battery;
a model-based estimator (130) which is designed to provide a time-window-related estimated charge (Qr) and which is connected to the operating variable input;
a zero crossing comparator (140) which is connected to the estimator (130) and which compares the estimated charge (Qr) or the rechargeable battery current (Im) with a maximum value in order to determine a zero crossing time;
a maximum comparator (142) which is connected to the estimator and which compares the magnitude of the estimated charge (Qr) or the rechargeable battery current (Im) with a minimum value, or which compares estimated charges (Qr) or detected rechargeable battery currents (Im) of two, three or more than three successive time windows with one another in order to detect a time of a scaling error detection on the basis of the difference;
an offset error determination device (150) which comprises an offset subtraction device which is designed to subtract the estimated charge (Qr), which is provided by the estimator, from the rechargeable battery current (Im) at the zero crossing time, which is provided by the zero crossing comparator (140), in order to provide the current measurement offset error as a result of the subtraction;
a scaling error determination device (152) which comprises an offset error subtraction device which is designed to subtract the current measurement offset error, which is provided by the offset error determination device, from the rechargeable battery current (Im) or from the time integral of the rechargeable battery current (Im) in order to compensate for the offset error of the rechargeable battery current (Im), wherein the scaling error determination device further comprises a ratio device which is designed to provide a ratio of the compensated rechargeable battery current (Im) in relation to the estimated charge (Qr) as a scaling error; and also a compensation device (160) which is designed to compensate for the provided offset error of the rechargeable battery current (Im), and also to compensate for the scaling error of the rechargeable battery current which has been compensated in respect of the offset error.

7. Apparatus according to Claim 6, wherein the estimator (130) comprises a physical model of the rechargeable battery (110), wherein the operating variable input is designed to receive a rechargeable battery terminal voltage, a rechargeable battery temperature, at least one further operating variable of the rechargeable battery which differs from the rechargeable battery current (Im), or a combination of these, wherein the operating variable is not directly dependent on the detected rechargeable battery current (Im) and influences the estimated charge (Qr).

8. Apparatus according to Claim 6 or 7, which further comprises an interpolator and also a temperature input, which is connected to said interpolator, for temperatures of the current detection sensor or a rechargeable battery current measuring device (114, 120) which is connected to the current detection sensor, wherein the interpolator interpolates a temperature error component of the provided offset error, of the provided scaling error or of both errors according to a predetermined linear temperature response, which is provided by the interpolator, of at least one component of the rechargeable battery current measuring device which comprises the current detection sensor, wherein the interpolator is designed to add the respective temperature error component to the current measurement offset error, the current measurement scaling error or both errors for additional temperature compensation.

9. Apparatus according to one of Claims 6-8, wherein the compensation device (160) comprises: a subtraction device which is designed to subtract the current measurement offset error, the current measurement scaling error or both errors from the rechargeable battery current (Im); a multiplication device which is designed to multiply an inverse value of the current measurement offset error, an inverse value of the current measurement scaling error or an inverse value of both errors from the rechargeable battery current (Im); or a correction error generator which is designed to generate a correction error and designed to correct the detected rechargeable battery current (Im) on the basis of the correction error, wherein the correction error generator comprises a PI controller which controls the correction error as a control variable, and the PI controller receives the current measurement offset error, the current measurement scaling error or a sum of these as a setpoint value, and has a control response according to which the correction error is approximated continuously to the current measurement offset error, to the current measurement scaling error or to a combination of both errors, and the compensation device is further designed to correct the rechargeable battery current (Im) according to the correction error which is provided by the correction error generator.

10. Apparatus according to one of Claims 6-9, which further comprises: a time window generator which defines a beginning and an end of the time window, wherein the beginning of a successive time window coincides with the end of the preceding time interval or follows it and all the time windows are of equal length or of different lengths, and the apparatus further comprises a standardization means which, when the time windows are of equal length, is designed to standardize the estimated charge (Qr) to the length of the time window or to 1, and, when the time windows are of different lengths, is designed to standardize the estimated charge (Qr) to the length of the time window, wherein the offset error determination device, the scaling determination device, the compensation device or a combination of these are connected to the time window generator and determine, subtract or compensate for the offset error only when the zero crossing comparator (140) determines the magnitude of the estimated charge (Qr) or of the rechargeable battery current (Im) below a maximum value over the entire duration of the time window, or the scaling error determination device (152), the compensation device (160) or both are connected to the time window generator and determine or compensate the scaling error only when the maximum comparator (142) determines a magnitude of the estimated charge (Qr) or of the rechargeable battery current (Im) above the provided minimum value for the entire duration of the time window, or when the time of the scaling error detection is within the time window.

## Revendications

1. Procédé pour mesurer avec compensation des erreurs le courant d'un accumulateur électrique, le procédé présentant les étapes suivantes :
prévoir un chargement (Qr) estimé sur une fenêtre temporelle, déterminé à partir de grandeurs de fonctionnement de l'accumulateur à l'aide d'un estimateur basé sur modèle et représentant la charge estimée qui s'est écoulée de l'accumulateur et qui a été apportée à l'accumulateur à l'intérieur de la fenêtre temporelle,
saisir à l'aide d'un détecteur de saisie du courant le courant d'accumulateur (Im) qui a été apporté à l'accumulateur et qui s'est écoulé de l'accumulateur pendant la fenêtre temporelle,
saisir l'instant de passage par zéro auquel le niveau de la charge estimée (Qr) ou du courant d'accumulateur (Im) sont inférieurs à une valeur maximale,
saisir un instant de maximum auquel le niveau de la charge estimée (Qr) ou du courant d'accumulateur (Im) présente essentiellement un maximum relatif ou une valeur supérieure à une valeur minimale,
déterminer une erreur de décalage de mesure du courant à l'instant du passage par zéro en comparant la charge estimée (Qr) au courant d'accumulateur (Im) saisi,
compenser le courant d'accumulateur (Im) en fonction de l'erreur de décalage de la mesure de courant,
déterminer une erreur d'échelle de mesure du courant à l'instant du maximum en comparant la charge estimée (Qr) au courant d'accumulateur estimé (Im) et soustraire l'erreur de décalage de mesure de courant ainsi déterminée du résultat de la comparaison ainsi obtenue
et compenser le courant d'accumulateur (Im) à l'aide de l'erreur d'échelle de mesure du courant.

2. Procédé selon la revendication 1, dans lequel l'étape qui consiste à prévoir la charge estimée (Qr) comprend :
la détermination de la charge estimée (Qr) à l'aide d'un estimateur qui comporte un modèle physique de l'accumulateur, les grandeurs de fonctionnement de l'accumulateur comprenant :
le courant d'accumulateur (Im) et au moins une autre grandeur de fonctionnement de l'accumulateur qui ne dépend pas directement du courant d'accumulateur (Im) saisi et qui agit sur la charge estimée (Qr), la ou les grandeurs de fonctionnement comportant la tension aux bornes de l'accumulateur, la température de l'accumulateur, au moins une autre grandeur de fonctionnement différente du courant d'accumulateur (Im) ou une combinaison de ces grandeurs.

3. Procédé selon les revendications 1 ou 2, dans lequel la compensation de l'erreur d'échelle de mesure du courant, la compensation de l'erreur de décalage de la mesure du courant ou les deux comprennent la saisie de la température du détecteur de saisie du courant ou de la température du dispositif de mesure du courant d'accumulateur raccordé au détecteur de saisie du coutant, la détermination d'une composante d'erreur de température de l'erreur de décalage de mesure du courant et de l'erreur d'échelle de mesure du courant dans une dépendance linéaire vis-à-vis de la température, la dépendance linéaire étant prédéterminée par un comportement en température au moins d'un composant du dispositif de mesure du courant d'accumulateur qui comprend le détecteur de saisie du courant et qui saisit le courant d'accumulateur (Im) et l'addition de la composante d'erreur de température à l'erreur de décalage de la mesure du courant et à l'erreur d'échelle de mesure du courant.

4. Procédé selon l'une des revendications précédentes, dans lequel la compensation comprend : la soustraction de l'erreur de décalage de mesure du courant, de l'erreur d'échelle de mesure du courant ou des deux erreurs du courant d'accumulateur (Im), la multiplication d'une valeur réciproque de l'erreur de décalage de mesure du courant, d'une valeur réciproque de l'erreur d'échelle de mesure du courant ou d'une valeur réciproque des deux erreurs du courant d'accumulateur (Im) ou la prévision d'une erreur de correction à l'aide de laquelle le courant d'accumulateur (Im) saisi est corrigé, l'erreur de correction étant apportée en tant que grandeur de réglage à un régulateur PI qui présente comme valeur de consigne l'erreur de décalage de la mesure de courant, l'erreur d'échelle de mesure du courant ou la somme de ces erreurs, pour approcher de manière continue et grâce au comportement de régulation du régulateur PI l'erreur de correction de l'erreur de décalage de mesure du courant, de l'erreur d'échelle de mesure du courant ou d'une combinaison des deux erreurs, le courant d'accumulateur (Im) étant corrigé en fonction de l'erreur de correction prévue par le régulateur PI.

5. Procédé selon l'une des revendications précédentes, dans lequel la prévision de la charge estimée (Qr) comprend : la prévision de la fenêtre temporelle en tant qu'une parmi plusieurs fenêtres temporelles successives et mutuellement adjacentes, toutes les fenêtres temporelles présentant une longueur associée et la charge estimée (Qr) étant normée ou non normée par rapport à la longueur associée, ou les fenêtres temporelles parmi les différentes fenêtres temporelles présentant des longueurs différentes et la charge estimée (Qr) étant normée par rapport à la longueur de la fenêtre temporelle associée, et en outre, pendant la totalité de la fenêtre temporelle, la charge estimée (Qr) et/ou le courant d'accumulateur (Im) mesuré sont essentiellement nuls, le niveau de la charge estimée (Qr) ou le courant d'accumulateur (Im) mesuré présentant essentiellement un maximum relatif ou une valeur supérieure à une valeur minimale, ou la charge estimée (Qr) associée à la fenêtre temporelle n'étant utilisée ni pour déterminer l'erreur de décalage de mesure du courant ni pour déterminer l'erreur d'échelle de mesure du courant.

6. Dispositif pour mesurer avec compensation des erreurs le courant de l'accumulateur électrique (110), le dispositif présentant :
une entrée de signal de courant destinée à être raccordée à un dispositif (114, 120) de mesure du courant d'accumulateur qui délivre un signal de courant qui représente le courant d'accumulateur (Im) pendant la fenêtre temporelle et qui est apporté à l'accumulateur (110) ou s'écoule de l'accumulateur (110),
une entrée de grandeur de fonctionnement prévue pour au moins une grandeur de fonctionnement de l'accumulateur,
un estimateur (130) basé sur modèle et conçu pour prévoir une charge (Qr) estimée dans une fenêtre temporelle et raccordé à l'entrée de grandeur de fonctionnement,
un comparateur (140) de passage par zéro relié à l'estimateur (130) et qui compare la charge estimée (Qr) ou le courant d'accumulateur (Im) à une valeur maximale pour déterminer un instant de passage par zéro,
un comparateur (142) de maximum raccordé à l'estimateur, qui compare le niveau de la charge estimée (Qr) ou le courant d'accumulateur (Im) à une valeur minimale ou qui compare les charges estimées (Qr) ou les courants d'accumulateur (Im) saisis dans deux, trois ou plus de trois fenêtres temporelles successives pour déterminer à l'aide de la différence l'instant de la saisie d'une erreur d'échelle,
un dispositif (150) de détermination de l'erreur de décalage qui comporte un dispositif de soustraction de décalage conçu pour soustraire la charge (Qr) estimée par l'estimateur du courant d'accumulateur (Im) à l'instant de passage par zéro délivré par le comparateur (140) de passage par zéro pour déterminer l'erreur de décalage de mesure du courant en tant que résultat de la soustraction,
un dispositif (152) de détermination de l'erreur d'échelle qui comporte un dispositif de soustraction d'erreur de décalage conçu pour soustraire l'erreur de décalage de mesure de courant délivré par le dispositif de détermination de l'erreur de décalage du courant d'accumulateur (Im) ou de l'intégrale par rapport au temps du courant d'accumulateur (Im) pour compenser l'erreur de décalage du courant d'accumulateur (Im), le dispositif de détermination de l'erreur d'échelle comportant en outre un dispositif de mise en rapport conçu pour déterminer le rapport entre le courant d'accumulateur (Im) compensé et la charge estimée (Qr) en tant qu'erreur d'échelle et
un dispositif de compensation (160) conçu pour compenser l'erreur de décalage du courant d'accumulateur (Im) qui a été déterminé ainsi que pour compenser l'erreur d'échelle du courant d'accumulateur qui a été compensée par rapport à l'erreur de décalage.

7. Dispositif selon la revendication 6, dans lequel l'estimateur (130) comporte un modèle physique de l'accumulateur (110), l'entrée de grandeur de fonctionnement étant conçue pour recevoir la tension aux bornes de l'accumulateur, la température de l'accumulateur, au moins une autre grandeur de fonctionnement de l'accumulateur différente du courant d'accumulateur (Im) ou une combinaison de ces grandeurs, la grandeur de fonctionnement ne dépendant pas directement du courant d'accumulateur (Im) saisi et agissant sur la charge estimée (Qr).

8. Dispositif selon les revendications 6 ou 7, qui comporte en outre un interpolateur auquel est raccordée une entrée de température qui reçoit la température du détecteur de saisie du courant ou d'un dispositif (114, 120) de mesure du courant d'accumulateur raccordé au détecteur de saisie du courant, l'interpolateur interpolant une composante d'erreur de température de l'erreur de décalage délivrée, de l'erreur d'échelle délivrée ou des deux échelles selon un comportement linéaire prédéterminé en température délivré par l'interpolateur d'au moins une composante du dispositif de mesure du courant d'accumulateur qui comporte le
détecteur de saisie du courant, l'interpolateur étant conçu pour ajouter la composante d'erreur de température à l'erreur de décalage de mesure du courant, à l'erreur d'échelle de mesure du courant ou aux deux erreurs pour réaliser une compensation supplémentaire de la température.

9. Dispositif selon l'une des revendications 6 à 8, dans lequel le dispositif de compensation (160) comporte un dispositif de soustraction conçu pour soustraire l'erreur de décalage de mesure du courant, l'erreur d'échelle de mesure du courant ou les deux erreurs du courant d'accumulateur (Im), un dispositif de multiplication conçu pour multiplier une valeur réciproque de l'erreur de décalage de mesure du courant, une valeur réciproque de l'erreur d'échelle de mesure du courant ou une valeur réciproque des deux erreurs du courant d'accumulateur (Im) ou un générateur d'erreur de correction conçu pour former une erreur de correction et pour corriger le courant d'accumulateur (Im) saisi à l'aide de l'erreur de correction, le générateur d'erreur de correction comportant un régulateur PI qui utilise l'erreur de correction comme grandeur de réglage, le régulateur PI contenant comme valeur de consigne l'erreur de décalage de mesure du courant, l'erreur d'échelle de mesure du courant ou une somme de ces erreurs et présentant un comportement de régulation selon lequel l'erreur de correction est approchée en continu de l'erreur de décalage de mesure de courant, de l'erreur d'échelle de mesure de courant ou d'une combinaison des deux erreurs, le dispositif de compensation étant en outre conçu pour corriger le courant d'accumulateur (Im) en fonction de l'erreur de correction délivrée par le générateur d'erreur de correction.

10. Dispositif selon l'une des revendications 6 à 9, comportant en outre un générateur de fenêtres temporelles qui définit le début et la fin d'une fenêtre temporelle, le début d'une fenêtre temporelle suivante coïncidant avec la fin de l'intervalle temporel précédent ou suivant celle-ci, toutes les fenêtres temporelles étant de même longueur ou étant de longueurs différentes, le dispositif comportant en outre un normeur qui est conçu pour normer la charge estimée (Qr) à la longueur de la fenêtre temporelle ou à 1 lorsque les fenêtres temporelles sont de même longueur, et qui est conçu pour normer la charge estimée (Qr) à la longueur de la fenêtre temporelle lorsque les fenêtres temporelles sont de longueur différente, le dispositif de détermination de l'erreur de décalage, le dispositif de détermination d'échelle, le dispositif de compensation ou une de leurs combinaisons étant reliés au générateur de fenêtres temporelles et le générateur de fenêtres temporelles étant conçu pour ne déterminer, soustraire ou compenser l'erreur de décalage que si le comparateur (140) de passage par zéro détermine que le niveau de la charge estimée (Qr) ou du courant d'accumulateur (Im) est inférieur à une valeur maximale pendant toute la durée de la fenêtre temporelle, ou le dispositif (152) de détermination d'erreur d'échelle, le dispositif de compensation (160) ou les deux sont reliés au générateur de fenêtres temporelles et le générateur de fenêtres temporelles étant conçu pour ne déterminer ou compenser l'erreur d'échelle que si le comparateur de maximum (142) a déterminé que pendant toute la durée de la fenêtre temporelle le niveau de la charge estimée (Qr) ou du courant d'accumulateur (Im) est supérieur à la valeur minimale prévue ou si l'instant de la détection de l'erreur d'échelle est situé à l'intérieur de la fenêtre temporelle.
